# FASCICULE DE BREVET EUROPEEN

(11) **EP 1 009 007 B1**
(45) Date de publication et mention de la délivrance du brevet: **07.01.2004**
(21) Numéro de dépôt: 99410158.2
(22) Date de dépôt: 16.11.1999
(51) Int. Cl.: H01H 47/32, H03K 5/1252

(54) **Dispositif de commande d'un électro-aimant avec entrée de commande locale**
Einrichtung zur Steuerung eines Elektromagneten mit örtlicher Steuerungseingabe
Control device for an electromagnet with a local control input

(30) Priorité: 07.12.1998 FR 9815555
(43) Date de publication de la demande: 14.06.2000
(73) Titulaire: Schneider Electric Industries SAS, 92500 Rueil-Malmaison (FR)
(72) Inventeur: Chelloug, Mustapha, Schneider Electric Ind. SA, 38050 Grenoble cedex 09 (FR); Durif, Ghislain, Schneider Electric Ind. SA, 38050 Grenoble cedex 09 (FR)
(74) Mandataire: Jouvray, Marie-Andrée

(56) Documents cités:
- DE-U- 9 403 299
- US-A- 5 394 018

## Description

L'invention concerne un dispositif de commande et un électro-aimant, l'ensemble comportant deux bornes d'alimentation, des moyens de redressement double alternance connectés aux bornes d'alimentation, au moins une bobine connectée en série avec un interrupteur électronique à la sortie des moyens de redressement, des moyens de commande de l'interrupteur électronique et une borne de commande locale destinée à être connectée à l'une des bornes d'alimentation par des moyens de commande locale pouvant prendre deux états, respectivement ouvert et fermé.

Classiquement la commande locale d'un électro-aimant, qu'il s'agisse d'un contacteur ou d'une bobine d'un auxiliaire électrique (électro-aimant de fermeture XF ou déclencheur à émission de courant MX) d'un disjoncteur, est constitué par un organe du type bouton-poussoir. On utilise aussi parfois une sortie d' automate programmable. Dans ce dernier cas surtout la présence de courants de fuite peut conduire à un actionnement intempestif de l'électro-aimant.

Le brevet US 5.394.018 décrit un contacteur à microprocesseur comportant des moyens pour distinguer de véritables signaux alternatifs de commande et des signaux d'entrée parasites dus à la présence de condensateurs connectés en parallèle sur l'organe de commande locale. Pour cela il comporte, entre l'organe de commande locale et l'entrée, des moyens permettant d'accroître le décalage existant entre un signal d'entrée parasite et un vrai signal d'entrée. La lecture du signal d'entrée se fait durant cette période de décalage. Un tel système est complexe et nécessite plus de composants qu'une entrée analogique (pont diviseur simple).

L'invention a pour but un ensemble permettant de faire cette distinction entre de vrais signaux de commande et des signaux parasites sans présenter les inconvénients du contacteur connu. Ce dispositif doit de plus fonctionner en continu et à 400 Hz.

Selon l'invention ce but est atteint par le fait que l'ensemble comporte un premier pont diviseur résistif, connecté à la sortie des moyens de redressement et comportant un point milieu connecté à une première entrée des moyens de commande de l'interrupteur électronique, et un second pont diviseur résistif, connecté entre la borne de commande locale et une borne de sortie des moyens de redressement et comportant un point milieu connecté à une seconde entrée des moyens de commande de l'interrupteur électronique, les moyens de commande comportant :
- des moyens d'échantillonnage quasi-simultanés pour fournir des échantillons associés des première et seconde tensions appliquées respectivement sur les première et seconde entrées des moyens de commande,
- des moyens de comparaison d'une première grandeur, représentative d'au moins un échantillon non nul de la seconde tension, et d'un pourcentage prédéterminé d'une seconde grandeur, représentative d'échantillons associés de la première tension,
- et des moyens de détection de l'état des moyens de commande locale, les moyens de commande locale étant considérés comme fermés lorsque la première grandeur est supérieure audit pourcentage.

Selon un développement de l'invention, les moyens de comparaison comportent des moyens pour comparer la première grandeur à des premier et second pourcentages de la seconde grandeur, les moyens de commande locale étant considérés comme fermés par les moyens de détection lorsque la première grandeur est supérieure, ou égale, au premier pourcentage et comme ouverts si elle est inférieure, ou égale, au second pourcentage, le second pourcentage étant inférieur au premier.

Dans un mode de réalisation préférentiel, les moyens de commande locale sont considérés par les moyens détection comme n'ayant pas changé d'état si la première grandeur est comprise entre les premier et second pourcentages.

Les première et seconde grandeurs sont, de préférence, formées respectivement par la somme d'un nombre prédéterminé d'échantillons successifs non nuls de la seconde tension et du même nombre d'échantillons associés de la première tension.

Le nombre d'échantillons utilisés pour le calcul des première et seconde grandeur est de préférence, égal ou supérieur à 3, et, par exemple, égal à 8. Une décision concernant l'état des moyens de commande locale est, de préférence, prise après un nombre prédéterminé de comparaisons successives conduisant au même résultat.

D'autres avantages et caractéristiques ressortiront plus clairement de la description suivante de modes particuliers de réalisation, donnés à titre d'exemples non limitatifs et représentés sur les dessins annexés dans lesquels :

La figure 1 illustre un dispositif selon l'invention.

La figure 2 représente une sortie d'automate programmable susceptible d'être utilisée à la place du bouton-poussoir de la figure 1.

Les figures 3a à 3d représentent, en fonction du temps, respectivement les formes d'onde des tensions U1 et U2, d'un ordre A de commande locale et de la tension U3 du dispositif selon la figure 1.

La figure 4 représente un mode de réalisation particulier d'un sous-programme de détermination de l'état de la commande locale d'un dispositif selon l'invention.

La figure 5 représente un mode de réalisation particulier d'un sous-programme de calcul des grandeurs G1 et G2.

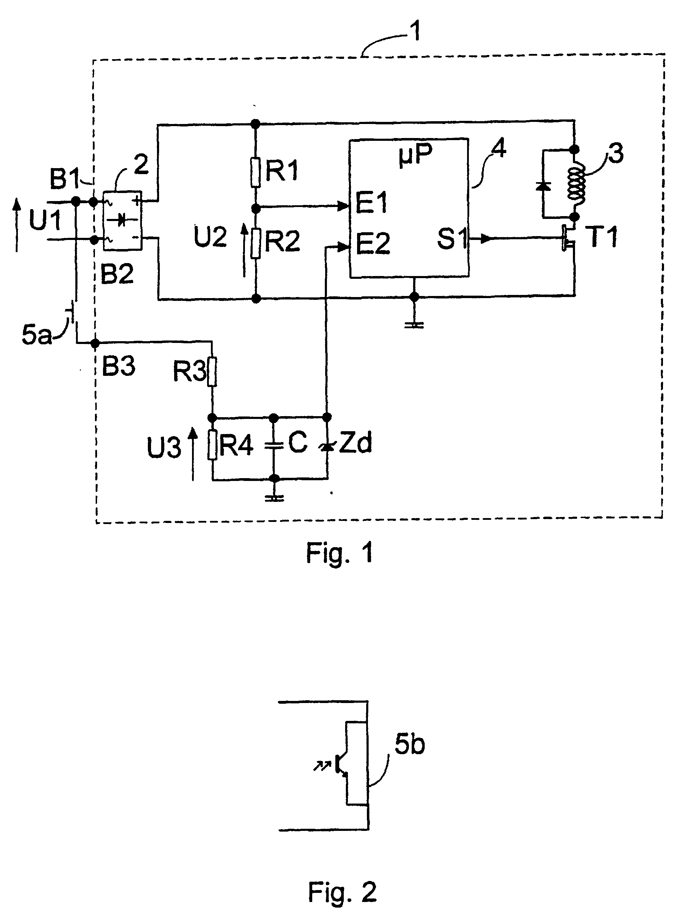

Sur la figure 1, le dispositif 1 de commande comporte deux bornes d'alimentation, B1 et B2, connectées à un redresseur 2 à double alternance, par exemple constitué par un pont de diodes. Les bornes de sortie, en continu, du redresseur alimentent une bobine 3 connectée en série avec un interrupteur électronique, constitué par un transistor T1, de type MOS. Un circuit 4 de commande, à microprocesseur, contrôle l'interrupteur électronique, une de ses sorties S1 étant connectée à l'électrode de commande du transistor T1. Une première entrée E1 du circuit 4 de commande est connectée au point milieu d'un premier pont diviseur résistif, constitué par deux résistances R1 et R2 connectées en série entre les bornes de sortie du redresseur 2.

Le dispositif 1 comporte une borne B3 de commande locale, destinée à être connectée à l'une des bornes d'alimentation, B1 sur la figure 1, par un organe de commande locale, constitué par un bouton-poussoir 5a sur la figure 1.

Un second pont diviseur résistif est constitué par deux résistances R3 et R4 connectées en série entre la borne B3 de commande locale et l'une des bornes de sortie du redresseur. Selon un mode de réalisation préférentiel, le second pont diviseur résistif est connecté entre la borne B3 et la masse. Un condensateur C et une diode Zener de protection ZD sont connectés en parallèle sur la résistance R4. Le point milieu du second pont diviseur résistif est connecté à une seconde entrée E2 du circuit 4 de commande.

Le bouton-poussoir 5a de la figure 1 peut être remplacé par une sortie d'automate programmable 5b, dont seuls les éléments indispensables à la compréhension sont schématisés à la figure 2. La sortie 5b est constituée par l'étage de sortie d'un coupleur optoélectronique, qui est rendu conducteur lorsqu'il doit transmettre un signal de commande locale au dispositif 1. La sortie d'un automate programmable peut également être constitué par un contact de relais.

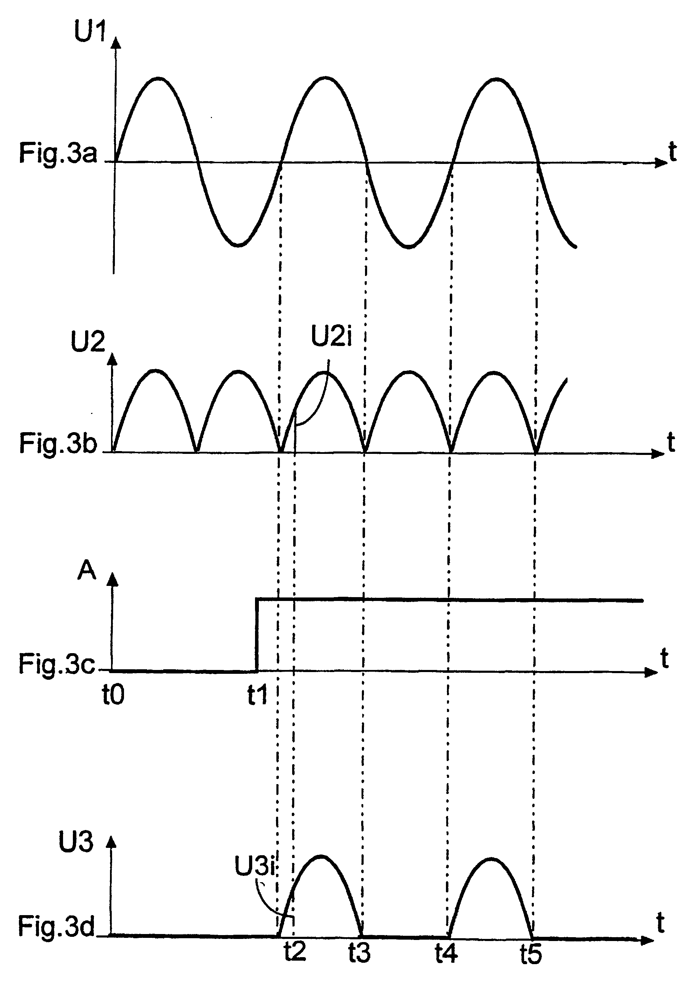

Le dispositif de commande fonctionne de la manière décrite ci-dessous en référence aux figures 3a à 3d, 4 et 5.

Les bornes d'alimentation B1 et B2 sont connectées en permanence à un réseau d'alimentation fournissant une tension d'alimentation U1. Dans le mode de réalisation représenté, la tension U1 est une tension alternative, sinusoïdale (figure 3a). La tension U1 est redressée par le redresseur 2 et la tension redressée double-alternance est appliquée aux bornes du premier pont diviseur résistif, R1, R2. La tension U2, aux bornes de la résistance R2, est appliquée à la première entrée E1 du circuit 4. La tension U2 (figure 3b) est donc représentative de la tension d'alimentation redressée. Le pont résistif permet d'adapter la tension d'entrée U2 à des valeurs compatibles avec un circuit de traitement numérique, par exemple à microprocesseur.

La tension U3, aux bornes de la résistance R4, est appliquée à l'entrée E2 du circuit 4. Entre les instants t0 et t1, aucun ordre de commande locale n'est fourni au dispositif (A = 0) et l'organe de commande locale (5a, 5b) est ouvert. Aucune tension n'est alors appliquée à la borne B3 et la tension U3 (figure 3d) est nulle.

A l'instant t1 un ordre de commande locale (A = 1) est fourni, soit par fermeture du bouton-poussoir Sa, soit par activation de la sortie 5b d'automate programmable. La borne B3 est alors connectée à la borne B2.

La tension U3 est une tension redressée monoalternance, par l'intermédiaire d'un diode du redresseur 2 connectée entre la masse et la borne B2. Ainsi, comme représenté sur les figures 3a à 3d, lorsqu' à l'instant t1 la tension U1 est négative, la tension U3 reste nulle jusqu'à l'alternance positive suivante de la tension U1. Puis, tant que A = 1, la tension U3 est nulle pendant les alternances négatives de U1 (t3 - t4) et représentative de la valeur de U1, ou de la tension appliquée à la borne B3, pendant les alternances positives de U1 (t2-t3, t4-t5).

Dans un mode de réalisation préférentiel les deux ponts diviseurs résistifs ont le même rapport de division, et de préférence R1 = R3 et R2 = R4. Ainsi les valeurs prises par les tensions U2 et U3 peuvent être comparées plus facilement.

L'excitation de la bobine 3 doit être commandée par le circuit 4 lorsqu'un ordre de commande est appliqué au dispositif 1, c'est à dire lorsqu'une tension est appliquée à la borne B3. Pour éliminer les ordres de commande parasites, dus par exemple aux courants de fuite en circuit ouvert des organes de commande locale, le circuit 4 compare une première grandeur G1, représentative de la tension U3, mesurée pendant les alternances non nulles (t2-t3, t4-t5) avec une seconde grandeur G2, représentative de la tension U2.

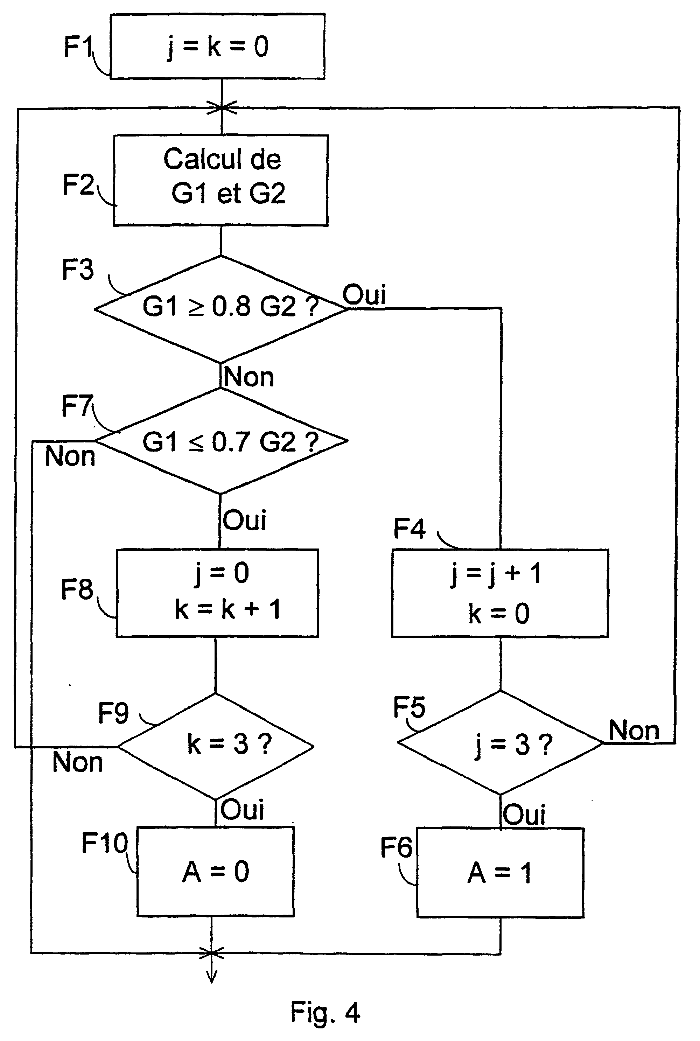

Le sous-programme de détection de l'état de l'organe de commande locale de la figure 4 schématise un mode de réalisation particulier du fonctionnement d'un microprocesseur du circuit 4. Pendant une première étape F1 d'initialisation, deux indicateurs j et k sont mis à 0. Puis pendant une seconde étape F2, le microprocesseur calcule les valeurs associées des première et seconde grandeurs G1 et G2.

Ensuite, pendant une étape F3, il compare la première grandeur G1 à un premier pourcentage prédéterminé de la seconde grandeur G2. Sur la figure 4, ce premier pourcentage est de 80 % , c'est dire que G1 est comparé à 0,8G2. Si la première grandeur G1 est supérieure ou égale à ce premier pourcentage (sortie OUI de F3), dans une étape F4 l'indicateur j est incrémenté (j=j +1) et l'indicateur k remis à 0. Puis, dans une étape F5, le microprocesseur vérifie si j est égal à 3. Si ce n'est pas le cas (sortie NON de F5) il se reboucle sur l'entrée de l'étape F2. Par contre, si c'est le cas (sortie OUI de F5), cela signifie que trois valeurs successives de G1 sont supérieures à 80% de G2 et l'organe de commande locale est considéré comme actif, c'est à dire fermé. Dans une étape F6, une valeur A représentative de l'ordre de commande locale est alors mise à une valeur logique correspondant à cet état, 1 sur la figure 4. Cet ordre sera ensuite interprété, de manière connue, par le microprocesseur de manière à commander l'excitation de la bobine 3.

Si pendant l'étape F3, il s'avère que la première grandeur G1 est inférieure à 0,8G2 (sortie NON de F3), alors le microprocesseur passe à une étape F7 dans laquelle la première grandeur G1 est comparée à un second pourcentage de la seconde grandeur G2, le second pourcentage étant inférieur au premier. Sur la figure 4, ce second pourcentage est de 70%, c'est à dire que G1 est comparée à 0,7 G2. Si la première grandeur G1 est inférieure ou égale à 0,7G2 (sortie OUI de F7), dans une étape F8 l'indicateur k est incrémenté (k = k + 1) et l'indicateur j remis à 0. Puis, dans une étape F9, le microprocesseur vérifie si k est égal à 3. Si ce n'est pas le cas (sortie NON de F9), il se reboucle sur l'entrée de l'étape F2. Par contre, si c'est le cas (sortie OUI de F9), cela signifie que trois valeurs successives de G1 sont inférieures à 70% de G2 et l'organe de commande locale est considéré comme inactif, c'est à dire ouvert. Dans une étape F10, la valeur A représentative de l'ordre de commande locale est alors mise à une valeur logique correspondant à cet état, complémentaire de la précédente, 0 sur la figure 4. Ceci sera ensuite interprété par le microprocesseur comme une absence d'ordre de commande locale et il n'y aura pas excitation de la bobine 3.

Par contre, si pendant l'étape F7, il s'avère que la première grandeur G1 est supérieure à 0,7G2 (sortie NON de F7), ce qui revient à dire qu'elle est comprise entre 0,7G2 et 0,8G2, le microprocesseur ne prend aucune décision concernant l'état de l'organe de commande locale, qui est alors considéré comme n'ayant pas changé d'état par rapport à son état précédent. La valeur A de l'ordre de commande locale est alors inchangée.

L'utilisation d'un hystéresis permet d'éviter des oscillations préjudiciables. Les valeurs préférentielles des pourcentages, à savoir 70 et 80% sont compatibles avec les normes des automates programmables. L'utilisation des indicateurs j et k conduit le microprocesseur à ne prendre une décision concernant l'état de l'organe de commande locale que lorsqu'un nombre prédéterminé (3 par exemple) de comparaisons successives conduit au même résultat.

La première grandeur G1 est constituée à partir d'au moins un échantillon U3i non nul de la tension U3. Le circuit de commande 4 procède à l'échantillonnage de la tension U3 avec une fréquence d'échantillonnage prédéterminée, fixe dans un mode de réalisation préférentiel. Simultanément il procède également à l'échantillonnage de la tension U2. Deux échantillons U2i et U3i prélevés simultanément sont associés. Les figures 3d et 3b représentent chacune respectivement un échantillon U3i non nul et l'échantillon U2i associé. En pratique l'échantillonnage ne se fait pas de façon simultanée, mais quasi-simultanée. Le microprocesseur du circuit 4 procède en fait à l'échantillonnage et à la conversion analogique/numérique de l'un des échantillons, U3i par exemple, puis à l'échantillonnage et à la conversion analogique/numérique de l'échantillon U2i associé, ou inversement. A titre d'exemple la période d'échantillonnage Te est de 0,625ms et la durée de la conversion analogique numérique est inférieure à 20µs (typiquement de l'ordre de 16 µs), ce qui peut-être négligé.

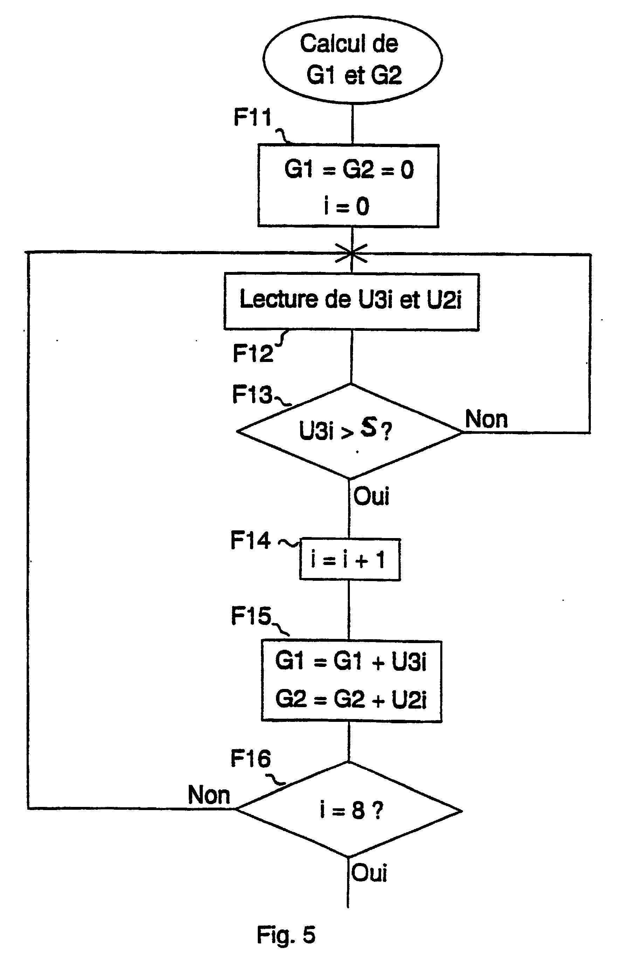

La figure 5 illustre un mode de réalisation préférentiel d'un sous-programme de calcul des grandeurs G1 et G2. Pendant une étape Fil d'initialisation les grandeurs G1 et G2 et un indicateur i sont mis à zéro. Puis, pendant une étape F12, le microprocesseur réalise la lecture d'un échantillon U3i et d'un échantillon associé U2i, c'est à dire qu'il échantillonne quasi-simultanément et convertit ces deux échantillons associés. Puis, dans une étape F13, il compare l'échantillon U3i à un seuil S prédéterminé, légèrement supérieur à zéro. Cette étape à pour but de déterminer si l'échantillonnage a eu lieu pendant une alternance non nulle, positive dans le mode de réalisation représenté, (t2-t3, t4-t5) de la tension U3. En effet la tension U3 étant redressée seulement en monoalternance tandis que la tension U2 est redressée en double alternance, une comparaison valable ne peut se faire que pendant les alternances non nulles de la tension U3. Le seuil S est, de préférence, choisi légèrement supérieur à 0, correspondant par exemple à quelques dizaines de millivolts (50mV par exemple) pour des tensions U2 et U3 maximales de l'ordre de quelques volts (5V par exemple), pour éliminer les effets parasites dus au bruit ou à des phénomènes d'offset.

Si l'échantillon U3i n'est pas supérieur au seuil S (sortie NON de F13), le microprocesseur se reboucle à l'entrée de F12, jusqu'à ce qu'il reçoive un échantillon non nul. Par contre, lorsque U3i est supérieur au seuil S (sortie OUI de F13), l'indicateur i est incrémenté (i = i + 1) pendant une phase F14. Cet indicateur est représentatif du nombre d'échantillons pris en compte pour le calcul de la grandeur G1 ou G2. Puis pendant une phase F15, les nouvelles valeurs intermédiaires des grandeurs G1 et G2 sont calculées G1 = G1 + U3i et G2 = G2 + U2i. Ensuite, dans une étape F16, le microprocesseur vérifie si l'indicateur i a atteint une valeur prédéterminée, 8 sur la figure. Si i = 8 (sortie OUI de F16) le calcul des grandeurs G1 et G2 est terminé et les valeurs calculées sont utilisées dans les étapes F3 et F4 de la figure 4. Par contre si, en F16, i n'est pas encore égal à 8 (sortie NON de F16), le calcul de G1 et G2 continue, le microprocesseur se rebouclant à l'entrée de l'étape F12 pour lire de nouveaux échantillons.

La valeur de 8 échantillons pour le calcul de G1 et G2 est une valeur préférentielle, mais l'invention n'est pas limitée à cette valeur et s'applique dès qu'un échantillon non nul de U3 est utilisé.

Dans le mode de réalisation préférentiel, la période d'échantillonnage Te est de 0,625 ms et 8 échantillons non nuls successifs sont utilisés pour le calcul de G1, 8 échantillons associés étant alors utilisés pour le calcul de G2. Pour un réseau à 50 Hz, la période d'échantillonnage retenue correspond à 16 échantillons par alternance (½ période). 8 échantillons correspondent donc à une ½ alternance non nulle. Dans le mode de réalisation représenté aux figures 3c et 3d, une première valeur de la première grandeur G1 est donc calculée au milieu de la première alternance, positive, suivant t1, et une seconde valeur de la première grandeur G1 est calculée à l'instant t3. Entre t3 et t4 la tension U3 restant nulle, aucune valeur de G1 ne peut être calculée et une troisième valeur de G1 est calculée au milieu de l'alternance positive (t4-t5) suivante. Trois valeurs de G2 ont été également calculées et chaque valeur de G1 comparée à la valeur correspondante de G2. Si le résultat des trois comparaisons est identique, on obtient une décision concernant l'état de la commande locale avant la fin de la seconde alternance positive (t4-t5) de U3 suivant t1, soit sensiblement du bout de 25 à 35 ms.

Les valeurs des grandeurs G1 et G2 ainsi obtenues sont, pour 50 Hz, représentatives de la valeur moyenne des tensions U3 et U2 correspondantes.

Si la fréquence de la tension d'alimentation U1 est différente, la fréquence d'échantillonnage et le nombre d'échantillons utilisés peuvent rester les mêmes. Des résultats satisfaisants sont obtenus pour des fréquences allant du continu à plus de 400 Hz. Dans le cas d'une tension d'alimentation continue, tous les échantillons obtenus après fermeture de l'organe de commande locale sont non nuls et les valeurs de G1 et G2 sont obtenues au bout de 15ms. Dans le cas d'une tension d'alimentation de 400 Hz, deux échantillons sont mesurés par ½ alternance et il faut au moins 4 demi-alternances non nulles de U3, soit 4 périodes de la tension d'alimentation U1, pour calculer une grandeur G1. La quasi-simultanéité de l'échantillonnage des tensions U2 et U3 permet d'obtenir une comparaison satisfaisante également dans de telles conditions.

L'invention n'est pas limitée aux modes de réalisation particuliers représentés sur les figures. En particulier l'organe de commande locale peut être connecté entre les bornes B3 et B2. Dans ce cas les alternances non nulles de U3 correspondent aux alternances négatives de la tension d'alimentation U1.

Le début du calcul des grandeurs G1 et G2 peut éventuellement être synchronisé automatiquement, par tout moyen approprié, sur le début d'une alternance non nulle de U3.

La fréquence d'échantillonnage, le nombre d'échantillons utilisés pour le calcul de chaque grandeur, et le nombre de comparaisons successives fournissant le même résultat pour permettre une décision sont choisis en fonction de la précision et de la rapidité de décision souhaitées. Au minimum, un échantillon U3i non nul est comparé à un pourcentage prédéterminé de l'échantillon U2i associé et le résultat de la comparaison est considéré comme représentatif de l'état de l'organe de commande locale.

Le traitement de l'entrée de commande locale est, de préférence, temporisée, par exemple pendant 1 s, lors de la mise sous tension du dispositif, de manière à éviter une détection intempestive d'un état actif de l'organe de commande locale en l'absence d'un tel état. En effet, ce type de détection intempestive peut intervenir en l'absence de temporisation, essentiellement en raison de phénomènes transitoires intervenant lorsque la borne de commande locale est reliée à une sortie d'automate dotée d'un condensateur de protection.

## Revendications

1. Dispositif de commande et électro-aimant, l'ensemble comportant deux bornes d'alimentation (B1, B2), des moyens de redressement double alternance (2) connectés aux bornes d'alimentation, au moins une bobine (3) connectée en série avec un interrupteur électronique (T1) à la sortie des moyens de redressement (2), des moyens (4) de commande de l'interrupteur électronique (T1) et une borne (B3) de commande locale destinée à être connectée à l'une (B2) des bornes d'alimentation par des moyens (5a, 5b) de commande locale pouvant prendre deux états, respectivement ouvert et fermé, **caractérisé en ce que** l'ensemble comporte un premier pont diviseur résistif (R1, R2), connecté à la sortie des moyens de redressement (2) et comportant un point milieu connecté à une première entrée (E1) des moyens (4) de commande de l'interrupteur électronique, et un second pont diviseur résistif (R3, R4), connecté entre la borne (B3) de commande locale et une borne de sortie des moyens de redressement (2) et comportant un point milieu connecté à une seconde entrée (E2) des moyens (4) de commande de l'interrupteur électronique, les moyens de commande comportant :
- des moyens d'échantillonnage quasi-simultané pour fournir des échantillons (U2i, U3i) associés des première et seconde tensions (U2, U3) appliquées respectivement sur les première et seconde entrées (E1, E2) des moyens (4) de commande,
- des moyens de comparaison d'une première grandeur (G1), représentative d'au moins un échantillon non nul de la seconde tension (U3), et d'un pourcentage prédéterminé d'une seconde grandeur (G2), représentative d'échantillons associés de la première tension (U2),
- et des moyens de détection de l'état des moyens (5a, 5b) de commande locale, les moyens de commande locale étant considérés comme fermés (A = 1) lorsque la première grandeur est supérieure audit pourcentage.

2. Ensemble selon la revendication 1, **caractérisé en ce que** les moyens de comparaison comportent des moyens pour comparer (F3, F7) la première grandeur (G1) à des premier et second pourcentages de la seconde grandeur (G2), les moyens de commande locale étant considérés comme fermés (A = 1) par les moyens de détection lorsque la première grandeur (G1) est supérieure, ou égale, au premier pourcentage et comme ouverts (A = 0) si elle est inférieure, ou égale, au second pourcentage, le second pourcentage étant inférieur au premier.

3. Ensemble selon la revendication 2, **caractérisé en ce que** les moyens de commande locale sont considérés par les moyens détection comme n'ayant pas changé d'état si la première grandeur (G1) est comprise entre les premier et second pourcentages.

4. Ensemble selon l'une des revendications 2 et 3, **caractérisé en ce que** le premier pourcentage est de l'ordre de 80% et le second pourcentage de l'ordre de 70 % .

5. Ensemble selon l'une quelconque des revendications 1 à 4 **caractérisé en ce que** les première (G1) et seconde (G2) grandeurs sont formées (F15) respectivement par la somme d'un nombre prédéterminé d'échantillons successifs non nuls de la seconde tension et par la somme du même nombre d'échantillons associés de la première tension.

6. Ensemble selon la revendication 5, **caractérisé en ce que**, la fréquence d'échantillonnage étant fixe, le nombre d'échantillons est supérieur ou égal à 3.

7. Ensemble selon la revendication 6, **caractérisé en ce que** le nombre d'échantillons est égal à 8.

8. ensemble selon l'une quelconque des revendications précédentes, **caractérisé en ce qu'**une décision concernant l'état des moyens (5a, 5b) de commande locale est prise après un nombre prédéterminé de comparaisons successives conduisant au même résultat.

9. Ensemble selon la revendication 8, **caractérisé en ce que** le nombre de comparaisons est égal à 3.

## Patentansprüche

1. Anordnung mit einer Betätigungseinrichtung und einem Elektromagneten, welche Anordnung zwei Stromversorgungsklemmen (B1, B2), an die Stromversorgungsklemmen angeschlossene Zweiweg-Gleichrichtmittel (2), mindestens eine in Reihe mit einem elektronischen Schalter (T1) an den Ausgang der Gleichrichtmittel (2) angeschlossene Spule (3), Mittel (4) zur Ansteuerung des elektronischen Schalters (T1) sowie eine Vorortbetätigungsklemme (B3) umfaßt, die dazu dient, über Vorortbetätigungsmittel (5a, 5b) mit zwei möglichen Schaltzuständen, nämlich 'ausgeschaltet' und 'eingeschaltet', mit einer (B2) der Stromversorgungsklemmen verbunden zu werden, **dadurch gekennzeichnet, daß** die Anordnung einen ersten ohmschen Spannungsteiler (R1, R2) umfaßt, der an den Ausgang der Gleichrichtmittel (2) angeschlossen ist und einen, an einen ersten Eingang (E1) der Mittel (4) zur Ansteuerung des elektronischen Schalters angeschlossenen Mittelanschluß aufweist, sowie einen zweiten ohmschen Spannungsteiler (R3, R4) umfaßt, der zwischen die Vorortbetätigungsklemme (B3) und eine Ausgangsklemme der Gleichrichtmittel (2) geschaltet ist und einen, an einen zweiten Eingang (E2) der Mittel zur Ansteuerung des elektronischen Schalters angeschlossenen Mittelanschluß aufweist, wobei die Ansteuermittel
- Abtastmittel zur quasisimultanen Abtastung umfassen, um einander zugeordnete Abtastwerte (U2i, U3i) einer ersten und einer zweiten Spannung (U2, U3) zu liefern, die einem ersten bzw. zweiten Eingang (E1, E2) der Ansteuermittel (4) zugeführt werden,
- Vergleichsmittel zum Vergleich einer ersten Größe (G1), die mindestens ein von null abweichendes Abtastsignal der zweiten Spannung (U3) abbildet, mit einem festgelegten Prozentsatz einer zweiten Größe (G2), die zugeordnete Abtastwerte der ersten Spannung (U2) abbildet,
- sowie Detektionsmittel zur Erkennung des Schaltzustands der Vorortbetätigungsmittel (5a, 5b) umfassen, wobei die Vorortbetätigungsmittel als eingeschaltet (A = 1) gelten, wenn die erste Größe über dem genannten Prozentsatz liegt.

2. Anordnung nach Anspruch 1, **dadurch gekennzeichnet, daß** die Vergleichsmittel Mittel (F3, F7) zum Vergleich der ersten Größe (G1) mit einem ersten und einem zweiten Prozentsatz der zweiten Größe (G2) umfassen, wobei die Vorortbetätigungsmittel von den Detektionsmitteln als eingeschaltet (A = 1) angesehen werden, wenn die erste Größe (G1) größer/gleich dem ersten Prozentsatz ist, bzw. als ausgeschaltet (A = 0) angesehen werden, wenn sie kleiner/gleich dem zweiten Prozentsatz ist, wobei der zweite Prozentsatz kleiner ist als der erste.

3. Anordnung nach Anspruch 2, **dadurch gekennzeichnet, daß** der Schaltzustand der Vorortbetätigungsmittel von den Detektionsmitteln als unverändert angesehen wird, wenn die erste Größe (G1) zwischen dem ersten und dem zweiten Prozentsatz liegt.

4. Anordnung nach einem der Ansprüche 2 und 3, **dadurch gekennzeichnet, daß** der erste Prozentsatz etwa 80 % und der zweite Prozentsatz etwa 70 % beträgt.

5. Anordnung nach irgendeinem der Ansprüche 1 bis 4, **dadurch gekennzeichnet, daß** die erste Größe (G1) und die zweite Größe (G2) aus der Summe einer bestimmten Anzahl von aufeinanderfolgenden, von null abweichenden Abtastwerten der zweiten Spannung bzw. der gleichen Anzahl zugeordneter Abtastwerte der ersten Spannung gebildet werden (F15).

6. Anordnung nach Anspruch 5, **dadurch gekennzeichnet, daß** bei fester Abtastfrequenz die Zahl der Abtastwerte größer oder gleich 3 ist.

7. Anordnung nach Anspruch 6, **dadurch gekennzeichnet, daß** die Zahl der Abtastwerte gleich 8 ist.

8. Anordnung nach irgendeinem der vorhergehenden Ansprüche, **dadurch gekennzeichnet, daß** eine Entscheidung bezüglich des Schaltzustands der Vorortbetätigungsmittel (5a, 5b) nach Durchführung einer bestimmten Anzahl von aufeinanderfolgenden Vergleichen mit identischem Ergebnis getroffen wird.

9. Anordnung nach Anspruch 8, **dadurch gekennzeichnet, daß** die Anzahl der Vergleiche gleich 3 ist.

## Claims

1. A control device and electromagnet, the assembly comprising two power supply terminals (B1, B2), full-wave rectifying means (2) connected to the power supply terminals, at least one coil (3) connected in series with an electronic switch (T1) to the output of the rectifying means (2), means (4) for controlling the electronic switch (T1) and a local control terminal (B3) designed to be connected to one (B2) of the power supply terminals by local control means (5a, 5b) able to take two states, respectively open and closed, **characterized in that** the assembly comprises a first resistive dividing bridge (R1, R2), connected to the output of the rectifying means (2) and comprising a mid-point connected to a first input (E1) of the control means (4) of the electronic switch, and a second resistive dividing bridge (R3, R4), connected between the local control terminal (B3) and an output terminal of the rectifying means (2) and comprising a mid-point connected to a second input (E2) of the control means (4) of the electronic switch, the control means comprising:
- means for almost simultaneous sampling to supply associated samples (U2i, U3i) of the first and second voltages (U2, U3) applied respectively to the first and second inputs (E1, E2) of the control means (4),
- comparison means for comparing a first quantity (G1), representative of at least one non-zero sample of the second voltage (U3), and a preset percentage of a second quantity (G2), representative of associated samples of the first voltage (U2),
- and detection means for detecting the state of the local control means (5a, 5b), the local control means being considered to be closed (A = 1) when the first quantity is greater than said percentage.

2. Assembly according to claim 1, **characterized in that** the comparison means comprise means for comparing (F3, F7) the first quantity (G1) with first and second percentages of the second quantity (G2), the local control means being considered to be closed (A = 1) by the detection means when the first quantity (G1) is greater than or equal to the first percentage and to be open (A = 0) if it is lower than or equal to the second percentage, the second percentage being lower than the first percentage.

3. Assembly according to claim 2, **characterized in that** the local control means are considered by the detection means not to have changed state if the first quantity (G1) is comprised between the first and second percentages.

4. Assembly according to one of the claims 2 and 3, **characterized in that** the first percentage is about 80% and the second percentage about 70%.

5. Assembly according to one of the claims 1 to 4, **characterized in that** the first (G1) and second (G2) quantities are respectively formed (F15) by the sum of a preset number of successive non-zero samples of the second voltage and of the same number of associated samples of the first voltage.

6. Assembly according to claim 5, **characterized in that**, the sampling frequency being fixed, the number of samples is greater than or equal to 3.

7. Assembly according to claim 6, **characterized in that** the number of samples is equal to 8.

8. Assembly according to any one of the foregoing claims, **characterized in that** a decision concerning the state of the local control means (5a, 5b) is taken after a preset number of successive comparisons leading to the same result.

9. Assembly according to claim 8, **characterized in that** the number of comparisons is equal to 3.
